Europäisches Patentamt

European Patent Office

Office européen des brevets

(11) Veröffentlichungsnummer: **0 303 224**
**A2**

## (12) EUROPÄISCHE PATENTANMELDUNG

(21) Anmeldenummer: **88112911.8**

(51) Int. Cl.⁴: **B01D 9/00**

(22) Anmeldetag: **09.08.88**

(30) Priorität: 12.08.87 DE 3726765
16.11.87 DE 3738840

(43) Veröffentlichungstag der Anmeldung:
15.02.89 Patentblatt 89/07

(84) Benannte Vertragsstaaten:
AT BE CH ES FR GB IT LI NL SE

(71) Anmelder: **INTOSPACE GmbH**
**Prinzenstrasse 17**
**D-3000 Hannover 1(DE)**

(72) Erfinder: **Plaas-Link, Andreas, Dr.**
**Langensalzastrasse 5**
**D-3000 Hannover 1(DE)**

(74) Vertreter: **König, Norbert, Dipl.-Phys. Dr. et al**
**Patentanwälte Leine & König**
**Burckhardtstrasse 1**
**D-3000 Hannover 1(DE)**

(54) **Kristallisationseinrichtung.**

(57) Eine Kristallisationseinrichtung (2), insbesondere zur Kristallisation von Proteinen unter Schwerelosigkeit, weist eine Kristallisationskammer auf, die aus einem elastischen Schlauch (8) besteht, dessen Enden verschließbar sind. Mit Hilfe einer Klemmvorrichtung (10) ist der Schlauchhohlraum in mehrere Kammern (14, 14', 14'') reversibel unterteilbar zur Aufnahme von verschiedenen Lösungen in Abhängigkeit vom durchzuführenden Kristallisationsverfahren.

FIG. 4

EP 0 303 224 A2

## Kristallisationseinrichtung

Die Erfindung betrifft eine Kristallisationseinrichtung, insbesondere zur Kristallisation von Proteinen unter Schwerelosigkeit.

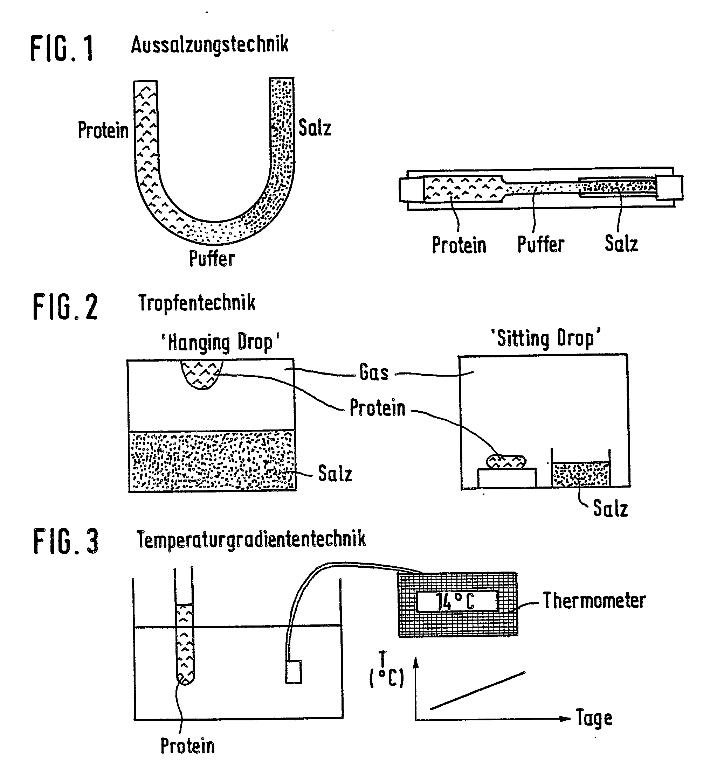

Die Kristallisation von Proteinen unter Schwerelosigkeit erfolgt heute vorwiegend durch drei Verfahren, und zwar das Aussalzungsverfahren, das Tropfenverfahren und das Temperaturgradientenverfahren. Diese Verfahren sind schematisch in den Figuren 1, 2 und 3 dargestellt.

Alle diese Verfahren zeichnen sich dadurch aus, daß gleichzeitig sehr verschiedene Ansätze durchgeführt werden. Das bedeutet, daß zur Kristallisation eines Proteins in der Regel sehr viele verschiedene Salzkonzentrationen, Additive und Temperaturen gleichzeitig ausgetestet werden. Dies gilt vor allen Dingen für das Tropfenverfahren. Die durchschnittliche Dauer eines Experimentes, bis die Kristallisation abgeschlossen ist, reicht von wenigen Tagen bis zu mehreren Monaten. Aus diesem Grunde ist es erforderlich, nicht erst nach negativem Experimentergebnis erneut eine andere Zusammensetzung der Lösung, Temperatur oder Salzkonzentration austesten zu können. Es werden daher bei allen drei Verfahren einfachste Materialien, wie Kapillaren, Standardgefäße und für das Aussalzungsverfahren vor allem bei den Tropfenverfahren besonders hergestellte Kästchen mit 10 bis 50 unterschiedlichen Feldern für die Anbringung der Proben verwendet. Hieraus ergibt sich die Forderung, den Wissenschaftlern zur Vorbereitung für Experimente, die mit µg-Mengen durchgeführt werden, einfache Anordnungen zur Durchführung der Experimente zur Verfügung zu stellen. Ferner ist es anzustreben, Verfahren und Vorrichtungen zur Durchführung der Verfahren anzubieten, die jeweils die in den Labors praktizierten Vorgehensweisen ermöglichen.

Das bisher von der Raumfahrtindustrie angebotene Konzept bei der Kristallisation von Proteinen arbeitet vorwiegend nach einem Aussalzungsverfahren, kann aber auch nach dem Temperaturgradientenverfahren arbeiten. Den bisherigen Verfahren haften etliche Nachteile an. Die Anzahl der zur Verfügung stehenden Kammern ist zu klein. Die Experimentatoren erwarten, daß ihnen pro Protein mehrere Kammern zur Verfügung gestellt werden, mindestens sechs Kammern wären durchschnittlich wünschenswert. Für Bodenversuche können nicht genügend Kammern für jeden Experimentator zur Verfügung gestellt werden. Um eine vernünftige Reihenuntersuchung bei den verschiedenen Versuchsbedingungen durchführen zu können, benötigen die Experimentatoren wesentlich mehr Kammern, die allerdings hinsichtlich Konstruktion und Ausführung identisch sein sollten mit den beim Raumflug verwendeten Kammern. An die Reinheit der Kristallisationskammern wird ein sehr hoher Anspruch gestellt. Bei den bisher vorgeschlagenen Bauprinzipien wird mit gefrästen und gedrehten Kammern gearbeitet, die darüberhinaus noch Fugen, Dichtungsringe und Nuten aufweisen, so daß die Reinigung der verwendeten Geräte Probleme aufwirft und die Gefahr besteht, daß nach erfolgter Benutzung eine einwandfreie Reinigung ohne sehr großen Aufwand schwer möglich ist.

Die Aufgabe der vorliegenden Erfindung besteht darin, eine Kristallisationseinrichtung anzugeben, bei der eine größere Zahl von Kammern verfügbar ist, die auf einfache Weise herstellbar und handhabbar sind.

Diese Aufgabe wird durch die Ausbildung gemäß Kennzeichen des Anspruchs 1 gelöst.

Vorteilhafte und zweckmäßige Weiterbildungen der erfindungsgemäßen Aufgabenlösung sind in den Unteransprüchen gekennzeichnet.

Durch die erfindungsgemäße Ausbildung können auf geringstem Raum eine große Zahl von Kristallisationskammern realisiert werden. Die Herstellung baugleicher Kristallisationskammern ist wesentlich erleichtert. Die Reinigung nach erfolgtem Gebrauch stellt kein Problem mehr dar. Die Anlieferung der für den Flug oder für Bodenvergleichsexperimente benötigten Proben erfolgt in den eigentlichen Kristallisationskammern, so daß ein Umfüllen, eine Verunreinigung und Verwechslung nicht mehr stattfinden kann. Die Volumina für die Kristallisation sind in großer Variationsbreite wählbar, beispielsweise von 1 µl bis 500 µl. Die erfindungsgemäße Kristallisationseinrichtung kann gleichermaßen für das Aussalzungsverfahren, das Tropfenverfahren oder das Temperaturgradientenverfahren verwendet werden. Jede Probe ist von den anderen Proben unabhängig. Eine Fehlfunktion in einem der Probenbehälter führt nicht zu einer Störung der Experimente in den anderen Proben. Als Material für die Probenbehälter wird ein Schlauch aus Silikonkautschuk verwendet, wodurch ein Brechen und eine Zerstörung des Probenmaterials weitgehend ausgeschlossen ist. Bei der Anwendung der "vapor-growth"-Technik in diesem Verfahren ist auf eine besonders einfache Art gewährleistet, daß die sich bildenden Kristalle schonend gekammert und zur Erde zurückgebracht werden können.

Die Erfindung soll nachfolgend anhand der beigefügten Zeichnung, die Ausführungsbeispiele zeigt, näher erläutert werden.

Es zeigt

Fig. 1 das Prinzip des Aussalzungsverfahrens,

Fig. 2 das Prinzip des Tropfenverfahrens,

Fig. 3 das Prinzip des Temperaturgradientenverfahrens,

Fig. 4 schematisch den prinzipiellen Aufbau der erfindungsgemäßen Kristallisationseinrichtung,

Fig. 5 + 6 zwei Ausführungsformen der bei der Einrichtung nach Fig. 4 eingesetzten Klemmeinrichtung,

Fig. 7 die erfindungsgemäße Kristallisationseinrichtung, eingeteilt in mehrere Kammern mit Hilfe der Klemmeinrichtung nach Fig. 5,

Fig. 8 schematisch eine Anordnung von erfindungsgemäßen Kristallisationseinrichtungen in mehreren Ebenen,

Fig. 9a, 9b schematisch die Anwendung der erfindungsgemäßen Kristallisationseinrichtung beim Aussalzungsverfahren,

Fig. l0a, 10b schematisch die Anwendung der erfindungsgemäßen Kristallisationseinrichtung beim Tropfenverfahren,

Fig. 11a, 11b die Anwendung der erfindungsgemäßen Kristallisationseinrichtung beim Temperaturgradientenverfahren,

Fig. l2a, 12b schematisch die Anwendung der erfindungsgemäßen Kristallisationseinrichtung bei der Kristallisation in einer Glaskapillare und

Fig. 13 eine Draufsicht auf eine Probenebene, beispielsweise eine Anordnung nach Fig. 8.

Fig. 14 schematisch einen Schnitt durch eine weitere Ausführungsform einer Klemmvorrichtung in Offenstellung,

Fig. 15 die Klemmvorrichtung nach Fig. 14 in der Klemmstellung,

Fig. 16 schematisch eine Vorrichtung zur Halterung der Kristallisationseinrichtung in Offenstellung,

Fig. 17 schematisch die Vorrichtung nach Fig. 16 in der Wirkstellung und

Fig. 18, 19 und 20 jeweils einen Längsschnitt durch einen elastischen Schlauch als Kristallisationseinrichtung mit Versteifungsmitteln.

Soweit sachlich möglich, wird nachfolgend gleichzeitig auf alle Figuren der Zeichnung Bezug genommen; für gleiche Bauteile wird in den Figuren jeweils das gleiche Bezugszeichen verwendet.

Die erfindungsgemäße Kristallisationseinrichtung 2 besteht aus einem seitlich beispielsweise mit Hilfe von Glasstopfen 4, 6 verschließbaren elastischen Schlauch 8. Der Schlauch 8 muß chemisch inert und transparent sein. Ein besonders geeignetes Material für den Schlauch ist Silikonkautschuk

Der Schlauch 8 wird durch eine Klemmvorrichtung 10 mit mehreren Klemmstellen 12, 12' in mehrere Kammern 14, 14', 14" unterteilt, in denen sich je nach dem angewendeten Verfahren eine Salzlösung, eine Proteinlösung, eine Pufferlösung oder ein Gas befinden. Die Klemmstellen bzw.

Klemmelemente sind verstellbar ausgebildet, so daß die jeweilige Kammergröße beliebig wählbar ist.

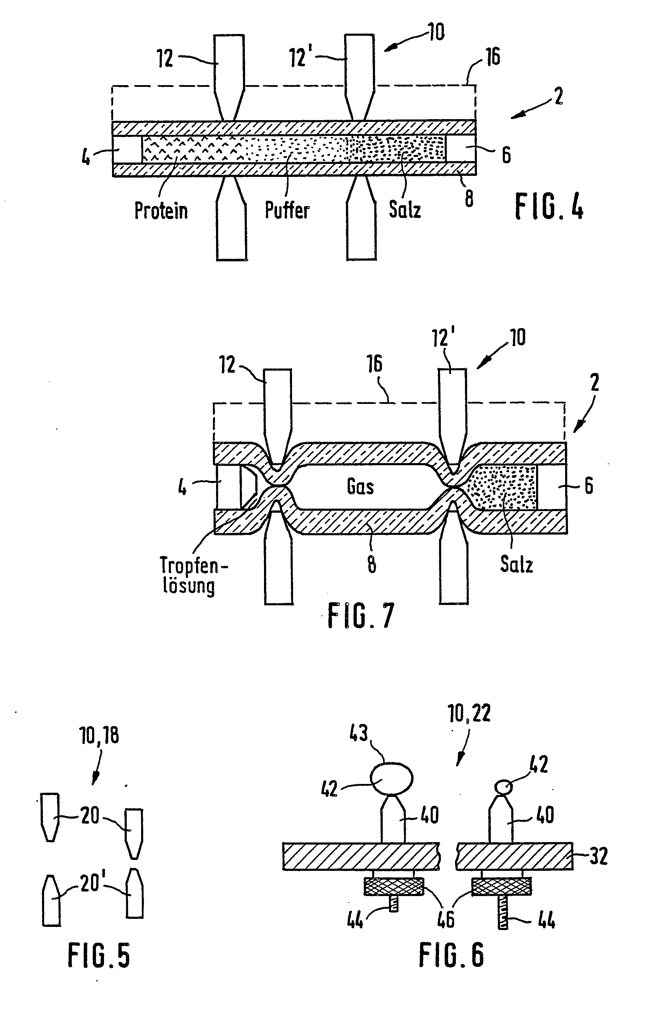

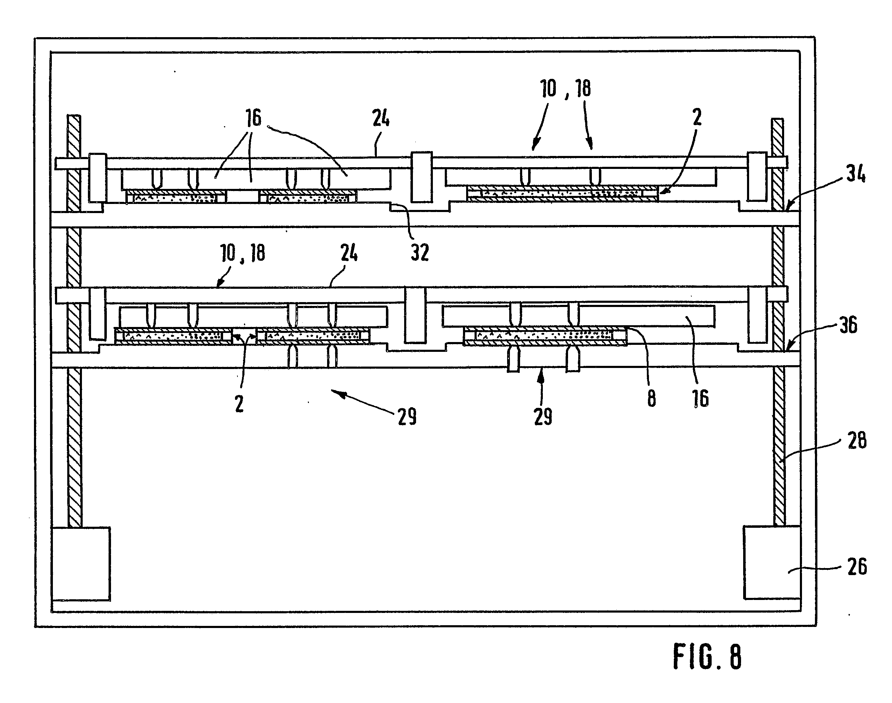

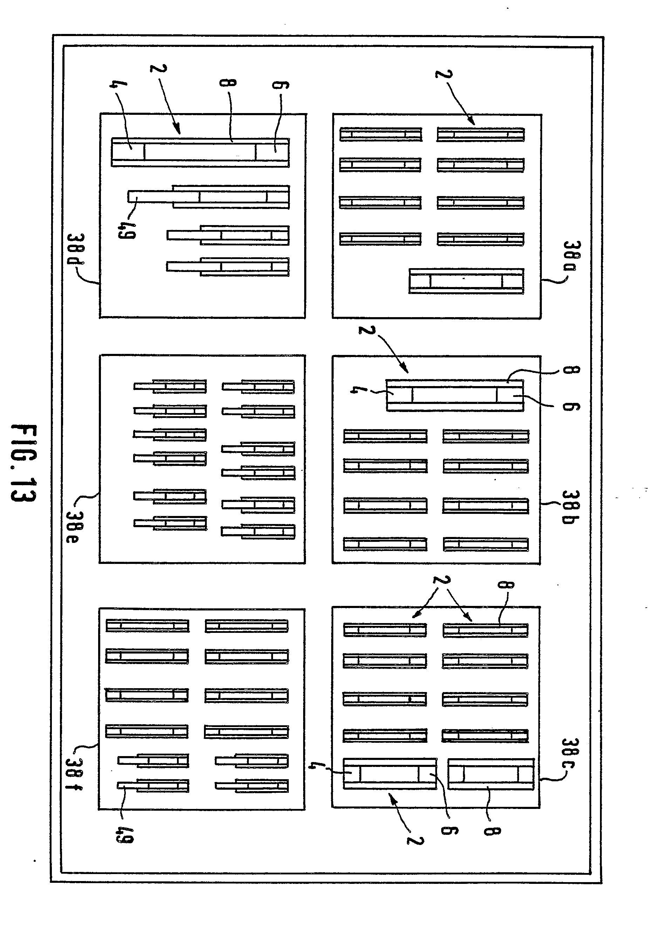

Die Kristallisationseinrichtung 2 kann ferner eine Kompressionseinrichtung 16 umfassen, die einen ständigen Druck auf den Schlauch 8 ausübt. Diese Kompressionseinrichtung 16 kann aus einem elastischen Material bestehen. Durch sie soll gegebenenfalls verhindert werden, daß sich beim Übergang von der Ruhephase, die in den Fig. 7, 9a, 10a, 11a und 12a dargestellt ist, in die Kristallisationsphase, die in den Fig. 4, 9b, 10b, 11b, 12b sowie auch in den Fig. 8 und 13 dargestellt ist, bei den verschiedenen Kristallisationsverfahren ein Unterdruck in den Kammern aufbaut, um so ein eventuelles Ausgasen in den Kristallisationskammern zu verhindern. Beim Lockern der Klemmvorrichtungen wird nämlich durch das Verschwinden der Klemmstellen das Kammervolumen größer.

Die Klemmvorrichtung 10 kann eine Preßklemmvorrichtung 18 mit konischen Klemmelementen 20, 20' gemäß Fig. 5 oder eine Schlaufenklemmvorrichtung 22 gemäß Fig. 6 sein. Die Preßklemmvorrichtung ist auch in allen anderen Figuren außer der Fig. 6 dargestellt.

Die Preßklemmvorrichtung kann beispielsweise eine Klemmplatte 24 aufweisen, an der die Klemmelemente 20, 20' befestigt sind und die über eine von einem Motor 26 oder dergl. angetriebene Spindel 28 verstellbar ist, vgl. Fig. 8. Als Preßgegenlager kann eine auf einem ortsfesten Auflager 30 angeordnete Bodenplatte 32 dienen. Als Gegenlager können aber auch einzelne, den Klemmelementen 20, 20' gegenüberliegende Klemmelemente vorgesehen werden, wie dies in den Fig. 4, 5, 7 und 9 bis 12 schematisch dargestellt ist.

Die Kompressionseinrichtung 16 befindet sich zwischen der Klemmplatte 24 und dem Schlauch 8.

In der Fig. 8 sind zwei Probenebenen 34, 36 dargestellt mit jeweils mehreren Probenfeldern. Die den Probenebenen zugeordneten Klemmvorrichtungen 10, 10' werden gemeinsam über die Spindel 28 verstellt. Es können mehr als die zwei dargestellten Probenebenen vorgesehen werden. Jedes Probenfeld kann über eine eigene Temperaturregeleinrichtung 29 verfügen, mit deren Hilfe sowohl Temperaturgradienten als auch konstante Temperaturen für die Kristallisationsschläuche 8 einregelbar sind.

Die Fig. 13 zeigt eine Draufsicht auf eine Probenebene mit sechs Probenfeldern 38a, b, c, d, e, f. Die Fig. 13 zeigt, daß Schläuche unterschiedlicher Größe und nach verschiedenen Kristallisationsverfahren arbeitend pro Feld vorgesehen werden können. Die Anordnung der Schläuche bleibt durch Verwendung eines Lochrasters für die Fixierung der Proben weitgehend frei. Es soll damit erreicht werden, daß jeder Experimentator in seinen Bodenexperimenten eine für ihn optimale Länge und Dicke seiner Kristallisationskammer erarbeiten kann, ohne daß eine Änderung der Hardware für Flugexperimente dadurch erforderlich wäre. Die Klemmebenen mit den Klemmelementen entweder für die Preßklemmung oder die Schlaufenklemmung weisen das gleiche Raster auf.

Die Schlaufenklemmeinrichtung 22 nach Fig. 6 besteht aus einer Hülse 40, die auf der Bodenplatte 32 der Probe, vgl. Fig. 8, in einem Loch eines Lochrasters befestigt ist. Durch die Hülse ist eine Schlaufe 42 beispielsweise aus einem Nylonfaden oder einem Draht 43 gezogen, die den Schlauch 8 umgibt. Mit Hilfe einer Gewindestange 44 kann die Schlaufe 42 zugezogen werden, wie dies ebenfalls in der Fig. 6 dargestellt ist. Durch Betätigung einer Rändelmutter 46 kann die Schlaufe zur Anpassung an unterschiedliche Durchmesser der Schläuche 8 vergrößert oder verkleinert werden. Die Gewindestangen 44 der einzelnen Klemmstellen können gleichzeitig betätigt werden, was nicht dargestellt ist.

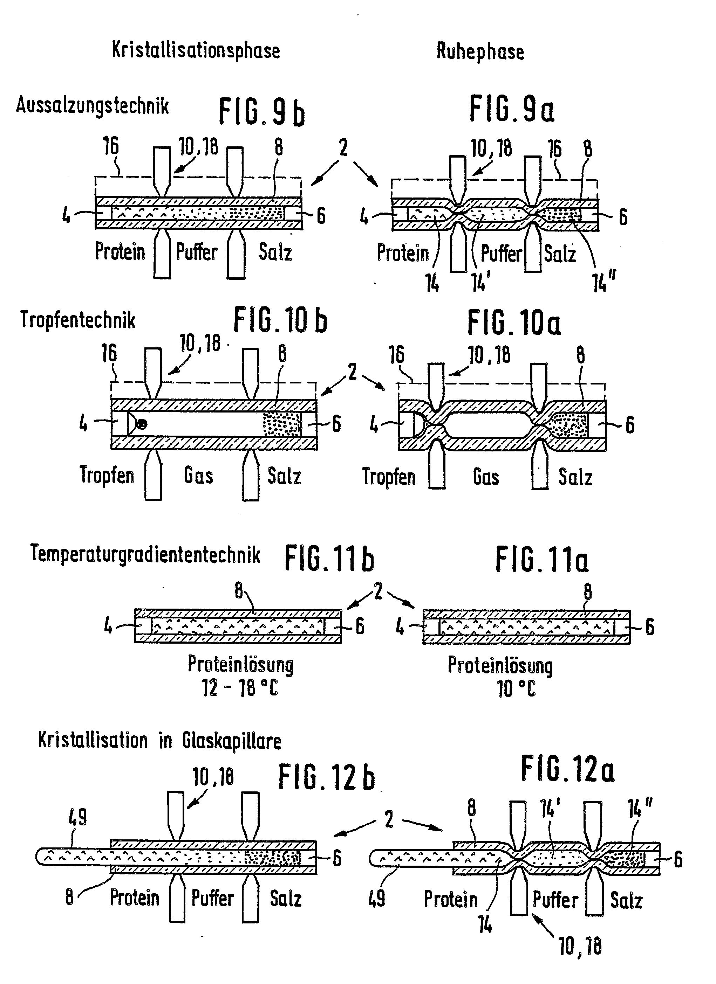

Die beschriebene Kristallisationseinrichtung kann für verschiedene Verfahren eingesetzt werden, wie dies in den Fig. 9a, b, 10a, b, 11a, b und 12a, b schematisch dargestellt ist.

Die Fig. 9a und 9b zeigen die Anwendung beim Aussalzungsverfahren. Der Schlauch 8 ist mit zwei planaren Glastopfen 4, 6 beidendig verschlossen. In der Ruhephase (Fig. 9a) ist der Schlauch 8 in drei Kammern 14, 14′, 14″ für eine Proteinlösung, eine Pufferlösung und eine Salzlösung unterteilt mit Hilfe der Klemmvorrichtung 10. Die Fig. 9b zeigt die Kristallisationsphase, in der die unterschiedlichen Lösungen innerhalb des Schlauches 8 ineinander diffundieren können.

Die Fig. 10a und 10b zeigen die Anwendung beim Tropfenverfahren, wobei in der Ruhephase (Fig. 10a) eine mikroskopische Salzlösung von einer Gasstrecke abgetrennt ist und die Gasstrecke wiederum von einem sehr kleinen Flüssigkeitsvolumen der Proteinlösung abgetrennt ist. Der Glasstopfen auf der Seite der Proteinlösung ist konisch ausgebildet. Die rund um den Tropfen 47 befindlichen Flächen sind so konstruiert oder behandelt, daß sie stark hydrophobe Oberflächeneigenschaften haben. Die Fläche an dem Glasstopfen sollte etwas besser benotzbar sein.

Die Fig. 11a und 11b zeigen die Anwendung der Kristallisationseinrichtung zur Kristallisation von Proteinen beim Temperaturgradientenverfahren. Dieses Verfahren erfordert in der Regel keine Kammerung. Die Silikonschläuche 8 werden nur durch planare Glastopfen verschlossen.

Die Fig. 12 und 12b zeigen die Anwendung der Kristallisationseinrichtung zur Kristallisation in einer Glaskapillare 49. Hierbei wird der Kristallisationsraum in Form einer einseitig zugeschmolzenen Glaskapillare 49 in den Silikonschlauch eingeschoben. Damit läßt sich zum einen eine uneingeschränkte Beobachtung des Kristallisationsvorganges erzielen, zum anderen werden eventuelle Nachteile der Silikonoberfläche bei manchen Membranproteinen vermieden. Das Einschieben der einseitig zugeschmolzenen Glaskapillare in einen Silikonschlauch eignet sich auch besonders gut für Kristallisationsverfahren, bei denen Flüssigkeit aus Kapillaren ausgedampft oder z.B. Alkohol in diese Kapillaren eingedampft werden soll. Bei einer solchen Technik befände sich im Gegensatz zur Darstellung in den Fig. 12a und 12b keine Pufferlösung zwischen der Salz- und der Proteinkammer, sondern ein Gasraum. Bei der Aufstellung mit Alkohol wäre statt der Salzlösung eine alkoholische Lösung vorzusehen.

Verschiedene Kammervolumina können durch Verwendung unterschiedlicher Schlauchgrößen realisiert werden. Bevorzugte Abmessungen der Schläuche sind 20 bis 80 mm Länge, 1,5 bis 5 mm Außendurchmesser und 1 bis 4 mm Innendurchmesser. Die Größe der Kammern selbst kann durch Verschiebung der Klemmelemente relativ zueinander und zu den Enden der Schläuche unterschiedlich eingestellt werden.

Die Klemmvorrichtung 10 ist vor allem für die Verwendung der Schläuche 8 zur Kristallisation unter Schwerelosigkeit bedeutungsvoll, um vorher eine Äquilibrierung der in den Schläuchen voneinander getrennten Flüssigkeiten zu vermeiden. Die Klemmvorrichtung erfüllt folgende Anforderungen:

Sie gewährleistet eine schmalbandige Klemmung und stellt das Öffnen des Schlauches nach Auflösen der Klemmung sicher.

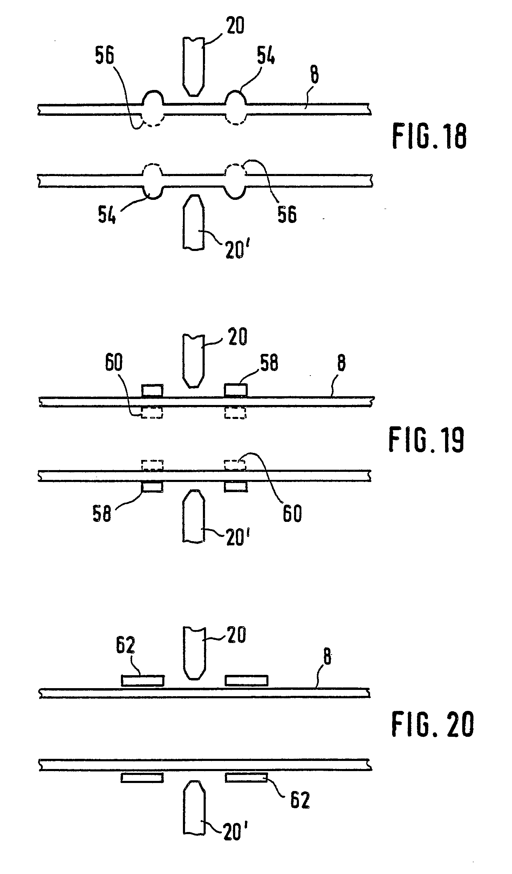

Eine schmalbandige Klemmung hat den Vorteil, daß nach Abschluß des Kristallisationsvorganges beim erneuten Schließen der Klemmelemente die entstandenen Kristalle weitgehend ungestört erhalten werden. Dies ist normalerweise insofern problematisch, als das Kristallwachstum gegebenenfalls an der Flüssigkeit-Gas- oder Flüssigkeit-Flüssigkeit-Grenzfläche abläuft, an der auch die Klemmung einsetzt. Die Fig. 18, 19 und 20 zeigen nun besondere Ausbildungen der Schläuche 8, durch die die Schmalbandigkeit der Klemmung unterstützt oder überhaupt erst erreicht wird. Die Schläuche 8 weisen hierzu direkt neben der Klemmung einen äußeren und/oder inneren Wulst 54, 56 auf, wie dies in der Fig. 18 dargestellt ist. Die Fig. 19 zeigt ein anderes Versteifungsmittel, und zwar in Form eines innen oder außen aufgekleben Verstärkungsringes 58, 60. Die Fig. 20 zeigt ein Versteifungsmittel in Form einer Manschette 62 zur Rundhaltung der Schläuche 8 neben der Klemmstelle.

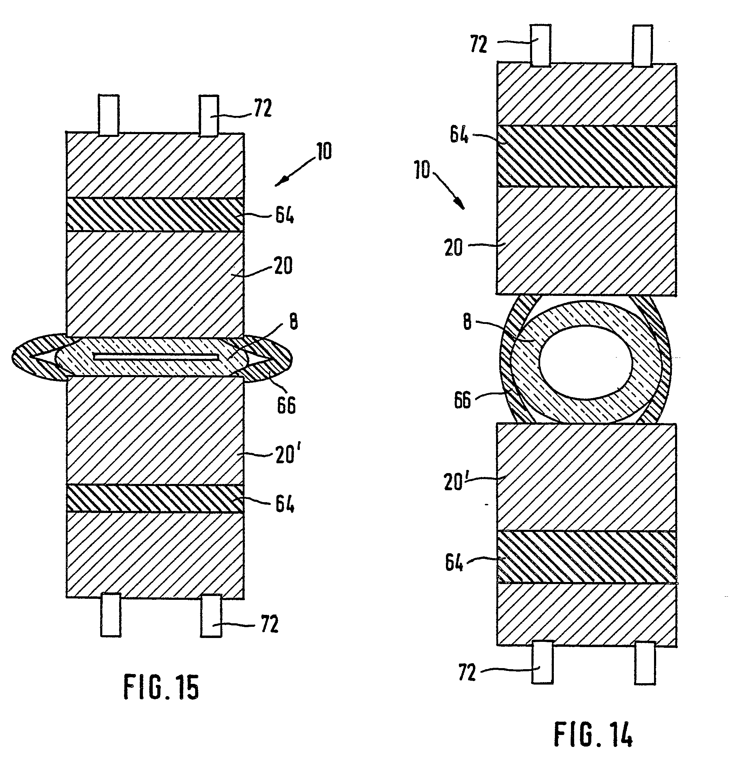

Um ein sicheres Öffnen der Klemmung nach dem Schließen zu gewährleisten, sind Ausbildungen vorgesehen, die in den Fig. 14 und 15 dargestellt sind. In die Klemmelemente, die vorzugsweise als Klemmkeile 20, 20' ausgebildet sind, sind hierzu elastische Elemente 64 eingebaut, durch die eine Begrenzung des Andrucks der Klemmelemente erreicht wird. Diese Andruckbegrenzung kann so gestaltet werden, daß eine geometrische Anpassung jeder Klemmung an die unterschiedlichen Schlauchdurchmesser nicht erforderlich ist. Dies ist möglich, wenn das elastische Element einen genügenden Kompressionsspielraum erlaubt.

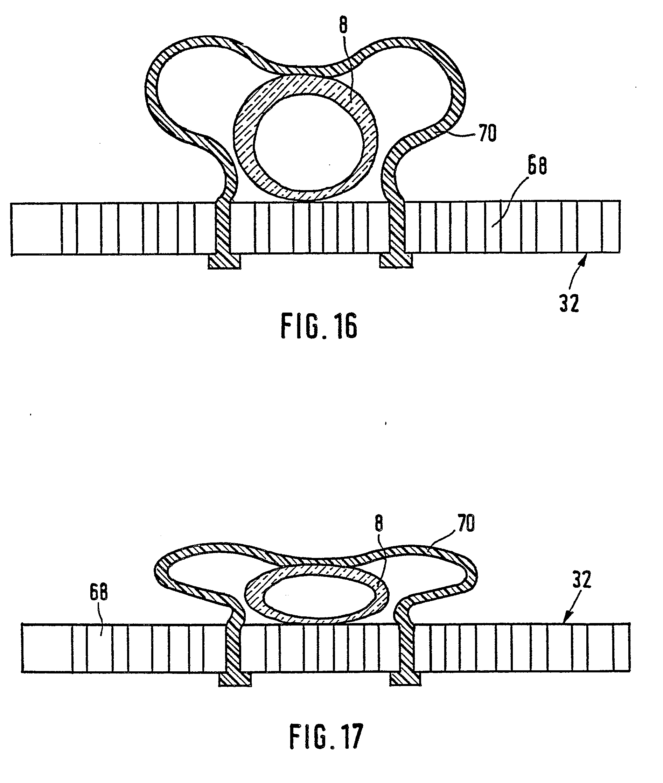

Ferner sind die Klemmkeile 20, 20' durch ein elastisches Mittel 66, z.B. eine Nylonschnur, ein Textilband oder dergl. miteinander an den Seiten verbunden. Bei geschlossener Klemmung ist dieses Mittel locker um den geklemmten Schlauch 8 herum angeordnet, wie in der Fig. 15 gezeigt ist. Bei geöffneter Klemmung ist das Band straff und übt einen seitlichen Druck auf den noch gestauchten Schlauch 8 aus, wodurch das Öffnen der Schläuche 8 erzwungen, wenigstens aber unterstützt wird. Die Bodenplatten 32, auf denen die Schläuche 8 montiert werden, weisen ein enges Lochraster 68 auf. Die Löcher 68 dieses Lochrasters dienen dazu, elastische Klammern 70 aufzunehmen, die zur Halterung der Schläuche verwendet werden. Die Fig. 16 und 17 zeigen eine solche Klammer 70, die hier die Form einer Spange hat. Diese elastischen Klammern 70 werden an den Enden der Schläuche angebracht und in das Lochraster 68 eingehakt. Der Zweck dieser elastischen Klemmung der Schlauchenden besteht darin, daß beim Öffnen der Klemmungen diese elastischen Klammern weiterhin einen positiven Druck auf den Schlauch 8 ausüben und dafür sorgen, daß zum einen der Schlauch leichter geöffnet werden kann und zum anderen kein Unterdruck im Schlauch entsteht, der gegebenenfalls zu einer Entgasung der im Schlauch enthaltenen Flüssigkeiten führen könnte.

Die einander gegenüberliegenden Klemmkeile 20, 20' weisen Zapfen 72 auf, die sowohl in ein Lochraster der Bodenplatte 32 als auch in ein Lochraster der verschiebbaren Klemmplatte 24 einsetzbar sind. Durch diese Ausbildung wird ein einfaches Mittel zur Arretierung der Klemmvorrichtung geschaffen, das nach Einbau der geklemmten Schläuche zwischen Bodenplatte und verschiebbarer Klemmplatte gelöst werden kann. Nach dem Einbau der geklemmten Schläuche zwischen Bodenplatte und verschiebbarer Klemmplatte wird die Klemmplatte so weit abgesenkt, daß sie die Klemmelemente bzw. die Klemmkeile über deren elastische Elemente 64 etwas komprimiert, so daß die Arretierung der Einzelklemmungen danach lösbar ist. Nach dem Einbau wird die Klemmung der einzelnen Schläuche durch die Lage der verschiebbaren Klemmplatte relativ zur Bodenplatte bestimmt.

Die elastischen Klammern 70 zur Schlauchbefestigung sowie die Klemmelemente 20, 20' zur Unterteilung der Schläuche 8 in die verschiedenen Kristallisationskammern passen in das Lochraster 68 sowohl der Bodenplatte 32 als auch der verschiebbaren Klemmplatte 24. Die Befestigung der Klemmelemente und der Klammern kann unterschiedlich erfolgen. Die Klammern 70 zur Schlauchbefestigung, die vorliegend etwa die Form einer Spange haben, lassen sich bei geeigneter Verformung in die Lochraster einspannen. Es ist auch möglich, diese Klammern zur Schlauchbefestigung und die Klemmelemente zur Unterteilung der Schläuche in mehrere Kristallisationskammern mit kleinen Schrauben auf den beiden Platten 32 und 24 zu montieren.

Eine weitere Möglichkeit besteht darin, die Klammern und Klemmelemente nach Positionierung durch Zapfen in den Lochrastern mit einem Klebemittel an den beiden Platten zu befestigen.

Das Lösen der Klemmvorrichtung soll zur Vermeidung von konvektiven Strömungen etwa zwei Stunden nach Startbeginn der Rakete erfolgen und sich über einen Zeitraum von vier Stunden hinziehen. Die dabei einsetzenden Flüssigkeitsverschiebungen liegen unter der Diffusionsrate der Substanzen.

Durch die beschriebene Ausbildung kann der Erhalt der an den Flüssigkeits-Flüssigkeit- bzw. Flüssigkeits-Gas-Grenzflächen entstandenen Kristalle während der Reentry-Phase gewährleistet werden (Kristalle entstehen auch inmitten der einzelnen Flüssigkeitsräume). Durch das Öffnen der Klemmelemente 20, 20' unter Schwerelosigkeit entsteht eine Volumenverminderung in dem Schlauch. Diese Verminderung wird durch Kompression der elastischen Klammern 70 zur Schlauchbefestigung an den Enden der Schläuche ausgeglichen. Dies führt innerhalb des Zeitraumes des Öffnens der Klemmelemente zu einer Volumenverschiebung der Flüssigkeiten in Richtung der Klemmelemente. Beim Wiederschließen der Klemmelemente läuft dieser Vorgang in umgekehrter Richtung ab, und es kommt zu einer Volumenverschiebung von den Klemmen in Richtung der elastischen Schlauchbefestigungsklammern. Es ist dabei anzunehmen, daß sich Kristalle, die sich unterhalb der Klemmelemente gebildet haben und durch die einsetzende Klemmwirkung sehr gefährdet werden, in Richtung der Schlauchenden aufgrund der Volumenverschiebung bewegen. Kristalle, die sich weiter entfernt von den Klemmelementen gebildet haben, sind nicht gefährdet.

Die beschriebene Kristallisationseinrichtung ist vorzüglich geeignet zur Untersuchung der Kristallisation von Proteinen unter Schwerelosigkeit, da die Experimentatoren nach Abschluß erfolgreicher Bodenversuche den Kristallisationsprozeß von mit Füllungen hergestellten Röhrchen mit Hilfe der beschriebenen Vorrichtung auf recht einfache und wirkungsvolle Weise durch die beschriebene Klemmvorrichtung vorerst unterbinden können.

## Ansprüche

1. Kristallisationseinrichtung, insbesondere zur Kristallisation von Proteinen unter Schwerelosigkeit, mit einer Kristallisationskammer, **dadurch gekennzeichnet**, daß die Kristallisationskammer aus einem elastischen Schlauch (8) besteht, dessen Enden verschließbar sind.

2. Einrichtung nach Anspruch 1, **dadurch gekennzeichnet**, daß eine Klemmvorrichtung (10) vorgesehen ist, mit der der Schlauchhohlraum in mehrere Kammern (14, 14', 14'') zur Aufnahme von verschiedenen Lösungen in Abhängigkeit vom durchzuführenden Kristallisationsverfahren reversibel unterteilbar ist.

3. Einrichtung nach Anspruch 2, **dadurch gekennzeichnet**, daß die Klemmvorrichtung (10) eine Preßklemmvorrichtung (18) oder eine Schlaufenklemmvorrichtung (22) ist.

4. Einrichtung nach Anspruch 2, **dadurch gekennzeichnet**, daß der Schlauch (8) durch eine Kompressionseinrichtung (16) beaufschlagbar ist.

5. Einrichtung nach Anspruch 4, **dadurch gekennzeichnet**, daß die Kompressionseinrichtung (16) einen ständigen Druck auf den Schlauch (8) ausübt.

6. Einrichtung nach Anspruch 5, **dadurch gekennzeichnet**, daß die Kompressionseinrichtung (16) aus einem elastischen Material besteht.

7. Einrichtung nach Anspruch 3, **dadurch gekennzeichnet**, daß die Preßklemmvorrichtung (18) beidseitig des Schlauches (8) angeordnete, einander gegenüberliegende, konische Klemmelemente (20, 20') aufweist.

8. Einrichtung nach Anspruch 3, **dadurch gekennzeichnet**, daß die Preßklemmvorrichtung (18) konische Klemmelemente (20, 20') und als Gegenlager eine Klemmplatte (24) aufweist.

9. Einrichtung nach Anspruch 3, **dadurch gekennzeichnet**, daß die Schlaufenklemmeinrichtung (22) eine Hülse (40) aufweist, die in ein Loch einer Bodenplatte (32) für den Schlauch (8) eingesetzt ist und durch die eine Schlaufe (42) aus einem den Schlauch umgebenden Faden oder Draht (43) gezogen ist, sowie eine Einrichtung (44, 46) zum Zusammenziehen und Lockern der Schlaufen.

10. Einrichtung nach einem der vorhergehenden Ansprüche, **dadurch gekennzeichnet**, daß die Klemmelemente der Klemmvorrichtung (10) verstellbar ausgebildet sind.

11. Einrichtung nach einem der vorhergehenden Ansprüche, **dadurch gekennzeichnet**, daß mehrere Probenebenen mit mehreren Schlauchfeldern vorgesehen sind und daß die Klemmvorrichtungen für alle Felder und alle Probenebenen gemeinsam betätigbar ausgebildet sind.

12. Einrichtung nach einem der vorhergehenden Ansprüche, **dadurch gekennzeichnet**, daß die Schläuche (8) aus Silikonkautschuk bestehen.

13. Einrichtung nach einem der vorhergehenden Ansprüche, **dadurch gekennzeichnet**, daß die Klemmelemente (20, 20') als Klemmkeile ausgebildet sind.

14. Einrichtung nach einem der vorhergehenden Ansprüche, **dadurch gekennzeichnet**, daß der elastische Schlauch (8) unmittelbar neben den vorgesehenen Klemmstellen einen äußeren und/oder inneren Versteifungswulst (54, 56) aufweist oder unmittelbar neben dieser Klemmstelle mit einem inneren und/oder äußeren Verstärkungs/Versteifungsring (58, 60) versehen ist.

15. Einrichtung nach Anspruch 14, **dadurch gekennzeichnet**, daß der Versteifungsring (58, 60) mit dem Schlauch (8) verklebt ist.

16. Einrichtung nach einem der vorhergehenden Ansprüche, **dadurch gekennzeichnet**, daß der elastische Schlauch (8) unmittelbar neben den vorgesehenen Klemmstellen eine Manschette (62) zur Rundhaltung aufweist.

17. Einrichtung nach einem der vorhergehenden Ansprüche, **dadurch gekennzeichnet**, daß die Klemmelemente (20, 20') ein elastisches Element (64) aufweisen zur Begrenzung des Klemmdruckes.

18. Einrichtung nach einem der vorhergehenden Ansprüche, **dadurch gekennzeichnet**, daß die einander gegenüberliegenden Klemmelemente (20, 20') mit Hilfe eines elastischen Mittels (66) miteinander seitlich verbunden sind.

19. Einrichtung nach Anspruch 18, **dadurch gekennzeichnet**, daß das Mittel (66) eine Schnur, ein Band, ein Streifen oder dergleichen aus einem elastischen Material ist.

20. Einrichtung nach Anspruch 18 oder 19, **dadurch gekennzeichnet**, daß das elastische Mittel (66) so ausgebildet ist, daß es bei geöffneter Klemmvorrichtung straff und einen seitlichen Druck auf den Schlauch ausübend am Schlauch (8) anliegt.

21. Einrichtung nach einem der vorhergehenden Ansprüche, **dadurch gekennzeichnet**, daß die Schläuche (8) auf Bodenplatten (32) montierbar sind, die ein Lochraster (68) aufweisen, in dessen Löchern elastische Klammern (70) zur Halterung der Schläuche befestigt sind.

22. Einrichtung nach Anspruch 21, **dadurch gekennzeichnet,** daß die Klammern (70) an den Enden der Schläuche angebracht sind und in das Lochraster der Bodenplatte (32) einhakbar sind.

23. Einrichtung nach Anspruch 22, **dadurch gekennzeichnet,** daß die Klammern (70) in Form von Spangen ausgebildet sind.

24. Einrichtung nach einem der vorhergehenden Ansprüche, **dadurch gekennzeichnet,** daß die Klemmelemente (20, 20') Zapfen (72) aufweisen, die in das Lochraster der Bodenplatte (32) und in ein Lochraster der beweglich ausgebildeten Klemmplatte (24) eingreifen.

25. Einrichtung nach Anspruch 1, **dadurch gekennzeichnet,** daß die Schlauchenden mit Hilfe von in diese Enden eingesetzten Glasstopfen (4, 6) verschlossen sind oder daß die Schlauchenden zugeschweißt sind.

26. Einrichtung nach Anspruch 25, **dadurch gekennzeichnet,** daß die Schläuche vor dem Verschließen der Enden mit einem inerten Schutzgas gefüllt werden.

EP 0 303 224 A2

# FIG. 1 Aussalzungstechnik

Protein    Salz

Puffer

Protein    Puffer    Salz

# FIG. 2 Tropfentechnik

'Hanging Drop'                    'Sitting Drop'

Gas

Protein

Salz

Salz

# FIG. 3 Temperaturgradiententechnik

14°C — Thermometer

$T$
$(°C)$

Tage

Protein

FIG. 4

FIG. 7

FIG.5

FIG.6

FIG. 8

EP 0 303 224 A2

EP 0 303 224 A2

Kristallisationsphase                    Ruhephase

Aussalzungstechnik      **FIG.9b**         **FIG.9a**

Tropfentechnik      **FIG.10b**         **FIG.10a**

Temperaturgradiententechnik   **FIG.11b**      **FIG.11a**

Proteinlösung                Proteinlösung
12 - 18 °C                   10 °C

Kristallisation in Glaskapillare   **FIG.12b**      **FIG.12a**

FIG.13

FIG. 15

FIG. 14

FIG. 16

FIG. 17

FIG.18

FIG.19

FIG. 20